# EUROPEAN PATENT APPLICATION

(11) **EP 1 109 118 A1**
(43) Date of publication of application: **20.06.2001**
(21) Application number: 99310140.1
(22) Date of filing: 16.12.1999
(51) Int. Cl.: G06F 17/50

(54) **Circuit configuration**

(71) Applicant: Lenzie, Robert S., Harperdon, Hertfordshire AL5 4JZ (GB)
(72) Inventor: Lenzie, Robert S., Harperdon, Hertfordshire AL5 4JZ (GB)
(74) Representative: Atkinson, Ralph

(57) **Abstract**

A configurable circuit is trained to generate an electrical signal coincident with an operator intention. A processor is instructed to generate and test circuits for a configurable circuit. An initial set of circuit configuration designs are created. The following steps are then performed repeatedly. Firstly, the circuit (**209**) is configured in response to selected ones of said designs. Secondly, an operator receives signals indicating an operator intention. Thirdly, an output from the configured circuit is correlated with the operator's signal. Fourthly, a preferred design is selected in response to this correlation. Finally, subsequent preferred designs are generated by selecting, mutating and combining characteristics from the selected preferred designs.

## Description

The present invention relates to a method of configuring an electronic circuit, and an apparatus that includes a circuit configured according to this method, arranged to generate a control signal for an electrical or electronic device.

Random events may determine a system's behaviour in a critical way, for example in weather patterns, and the ability to identify systemic influences upon such behaviour has a high value. The ability to unify many different records of data, for example, medical records from multiple health authorities, permits sophisticated analysis techniques to be applied. These may be used to reveal previously hidden systemic anomalies within the data, that can be used to improve the performance or predictability of the system. The combination of diverse data records for analysis in this way is known as meta-analysis.

The statistical method of meta-analysis has been applied to the results of experiments in consciousness research and small but persistent anomalies have been observed. Results and details of such experiments are described in "Consciousness and Anomalous Physical Phenomena", PEAR Technical Report 95004, Princeton Engineering Anomalies Research. An account of meta-analysis and its application to consciousness research is given in "The Conscious Universe" by Dean I. Radin, ISBN 0-06-251502-0.

In US patent 5,830,064 a low cost electronic random event generator is disclosed having characteristics that are preferable for detecting consciousness-related phenomena. These characteristics are usually provided by high cost laboratory random event generators. A small but statistically significant bias in a set of random numbers is the usual method for identifying an anomalous characteristic. In US patent 5,830,064 a system is disclosed in which random swapping of polarity is used in order to prevent a systematic introduction of a positive or negative bias in the numbers that are generated. It is intended that outputs from the random number generator are analysed, and the results of analysis can be used to control toys or electrical devices. Alternatively the output may be supplied to a computer for processing.

The magnitude of statistically significant random event modifications due to conscious operator intention is extremely small and extremely unreliable. The deviation of random events from expected behaviour is usually in the order of less than one percent when it occurs. It is only the application of meta-analysis to the results of several thousand tests that reveals there is an effect at all. An average operator's ability to influence a random event generator is so slight that it is difficult to imagine any such device providing a reliable response to an operator intention.

According to a first aspect of the present invention, there is provided a method of configuring a circuit to be responsive to an operator intention, wherein a configurable circuit has a plurality of function means and re-configurable routing means for said function means, characterised by the steps of:
generating designs for configurations of said circuit; followed by repeated steps of:
(a) testing said circuit designs by measuring an indication of responsiveness to an operator or intention:
(b) selecting preferred designs and
(c) generating next designs from said preferred designs.

In a preferred embodiment, the step of generating subsequent preferred designs by combining characteristics from selected preferred designs includes selecting, combining and mutating routine characteristics.

According to a second aspect of the present invention, there is provided apparatus for training a configurable circuit to generate an electrical signal coincident with an operator intention, wherein a processing means is instructed to generate and test circuits for a configurable circuit, characterised by creating means for creating an initial set of circuit configuration designs; configuring means for configuring said circuit in response to selected ones of said design; receiving means for receiving an operator signal indicating an operator intention; correlating means for correlating an output from said configured circuit with said operator signal; selecting means for selecting a preferred design in response to said correlation; and generating means for generating subsequent preferred designs by combining characteristics of selected preferred designs.

The invention will now be described by way of example only, with reference to the accompanying drawings, of which:
*Figure 1* shows a configuration apparatus including a computer and a monitor;
*Figure 2* details components of the computer shown in *Figure 1,* including a memory and a field-programmable gate array;
*Figure 3* details the arrangement of gate cells in the field-programmable gate array shown in *Figure 2*;
*Figure 4* details a cell of the type shown in *Figure 3;*
*Figure 5* details contents of the memory shown in *Figure 2*, including design data;
*Figure 6* details design data shown in *Figure 5*, including a cell design and a cell configuration;
*Figure 7* details procedures performed using the configuration system shown in *Figure 1*, including steps of generating a downloadable file, correlation, displaying results and creating the next generation;
*Figure 8* details signal data used by the step of correlation shown in *Figure 7;*
*Figure 9* details the display shown on the monitor shown in *Figure 1* in response to the correlation step shown in *Figure 7;*
*Figure 10* details the step of generating a downloadable file shown in *Figure 7*, including steps of generating configuration data, route elimination and conflict processing;
*Figure 11* illustrates the step of creating the next generation, shown in *Figure 7;*
*Figure 12* details the step of generating configuration data, shown in *Figure 10,* including a step of translating input values;
*Figure 13* details the step of translating input values shown in *Figure 12*;
*Figure 14* details the step of route elimination shown in *Figure 10;*
*Figure 15* details the step of conflict processing shown in *Figure 10;* and

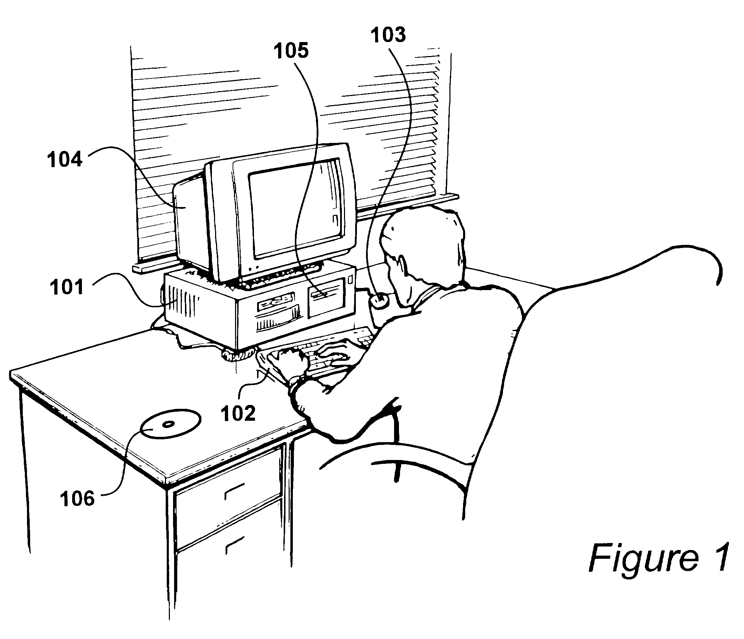

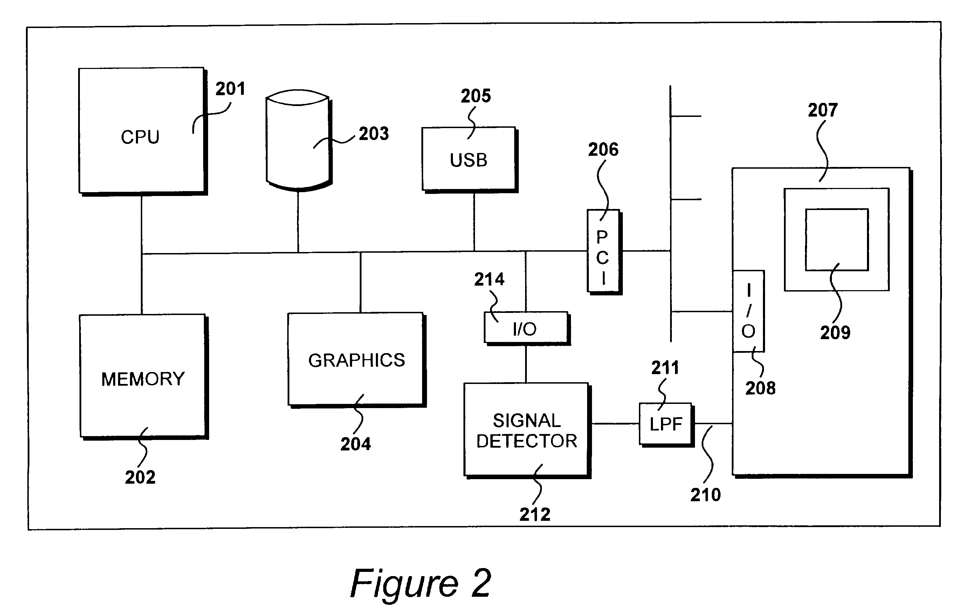

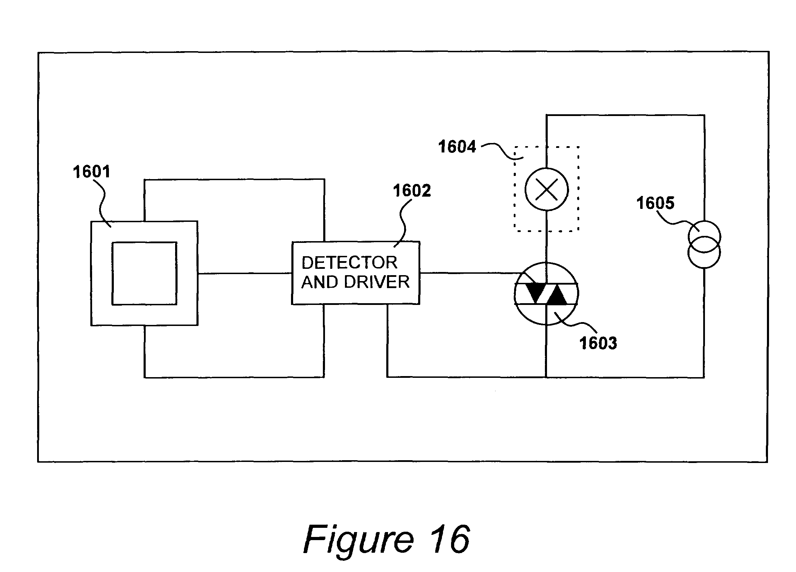

*Figure 16* details an application of the circuit design evolved using the system shown in *Figure 1.* Apparatus for configuring an electronic circuit is shown in *Figure 1*. An operator has access to a computer system **101**, via a keyboard **102** and a mouse **103**. The system has a monitor **104** and a CD-ROM reader **105** capable of reading a CD-ROM **106** containing instructions executable by the computer **101**. In addition, the system has additional circuitry for configuring a configurable circuit. Hardware details of the computer **101** are shown in *Figure 2*. The computer circuit is based on a Pentium III central processing unit (CPU) **201**, running at seven hundred and thirty-three megahertz. The CPU **201** includes on-chip cache memory running at the same speed as the CPU. An additional main memory **202** includes one hundred and twenty-eight megabytes of dynamic memory, in which most of the instructions and data are stored during use. A hard disk drive **203** provides thirteen gigabytes of non-volatile long-term storage, from which programs, originally installed from CD-ROM **106**, are loaded and on which data may be stored.

A graphics circuit **204** provides additional processing capability for rendering images that are to be displayed on the monitor **104**. A universal serial bus (USB) interface **205** provides connectivity to the keyboard **102**, mouse **103** and other peripherals, such as a printer.

A peripheral interconnect bus (PCI) interface **206** provides connectivity to additional circuitry in PCI sockets within the casing of the computer **101**. A special purpose circuit board **207** includes input/output (I/O) circuitry **208**, to facilitate communications between the processor **201** and an XC6216 field-programmable gate array (FPGA) integrated circuit **209**, manufactured by Xilinx Inc. Data for the XC6216 is available from "The Programmable Logic Data Book" at http://www.xilinx.com. One of the pins of the FPGA **209** has an output connection **210** that is supplied to a low pass filter (LPF) **211**. The low pass filter removes signal components above two kilohertz in frequency.

An output from the low pass filter **211** is supplied to a signal detector **212**. A suitable signal detector is a Pico Scope ADC200, details of which are available at http//www.picotech.co.uk. The signal detector **212** is connected to the rest of the computer circuit via a parallel I/O circuit **214**. The signal detector **212**, in combination with the rest of the computer performs a function substantially similar to that of an oscilloscope. Signals supplied to it from the FPGA 209 via connection **210** and the low pass filter **211**, are converted from an analogue form into digital samples, that are then supplied to the processor **201** for storage and analysis. The arrangement in *Figure 2* permits configurations of the FPGA **209** to be generated by the processor **201** in the form of circuit designs. These are then converted into configuration data, supplied to the FPGA **209**, and tested using the signal detector **212** and processor **201**.

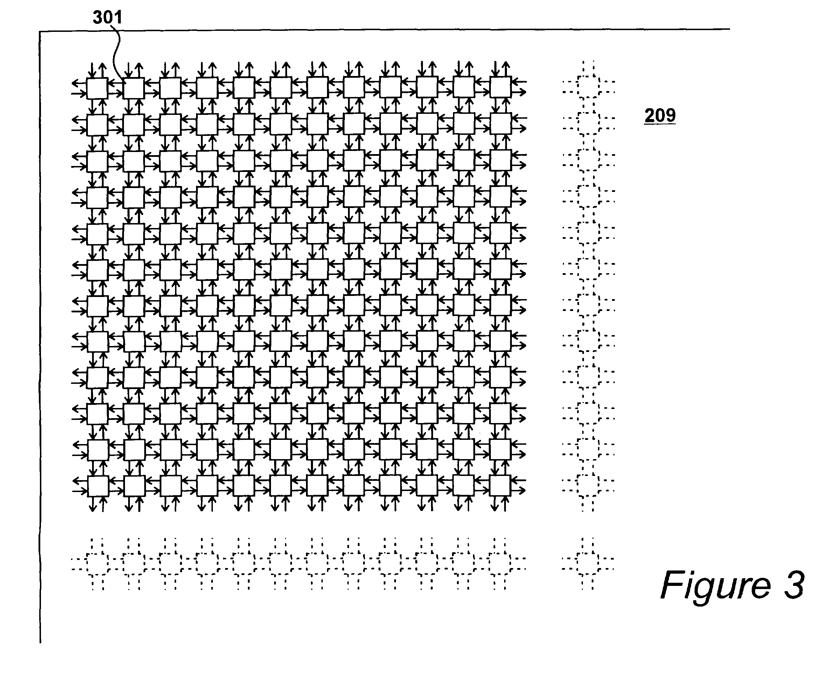

The configurable circuitry in the Xilinx XC6216 FPGA **209** is detailed in *Figure 3*. The FPGA **209** is a sea-of-gates type configurable logic circuit, comprising an array of sixty-four by sixty-four logic cells **301**. Each cell may be configured to perform a particular logical function. Furthermore, each cell is configurable to provide routing between its own inputs and outputs, and those of other cells. Cell function and routing is defined uniquely for each cell by an eighteen bit binary word held in memory bit locations physically adjacent to each cell. In the XC6216, this memory is implemented as static RAM, so that the device may be reconfigured any number of times. The configuration data is supplied via I/O circuitry **208**, in a serial format, to the FPGA, each time a new configuration is required.

At the edges of the array of logic cells **301** interface circuitry is provided to the pins of the chip package. One of these pins provides the output signal **210**. Routing between cells **301** in the FPGA **209** requires careful optimisation by routing software when design configurations are to be implemented.

The routing of circuitry, whether in an FPGA or by discrete circuitry, is a well known problem, and is the subject of considerable dedicated technological effort. In order to alleviate some of the difficulty of providing routes for circuit designs, the XC6216 includes a hierarchy of routing resources. Cells **301** may communicate directly with their neighbours, or route signals without providing a logic function. At a higher level, cells are grouped into four by four arrays, so that routing may be provided directly between clusters of four by four cells. Further hierarchical routing is provided for groupings of sixteen by sixteen and sixty-four by sixty-four cells, as is explained in the data sheet for this circuit. When designing a configuration for the XC6216, or any other circuit of sufficient complexity, routing is a problem that restricts the characteristics and complexity of the circuit that can be achieved.

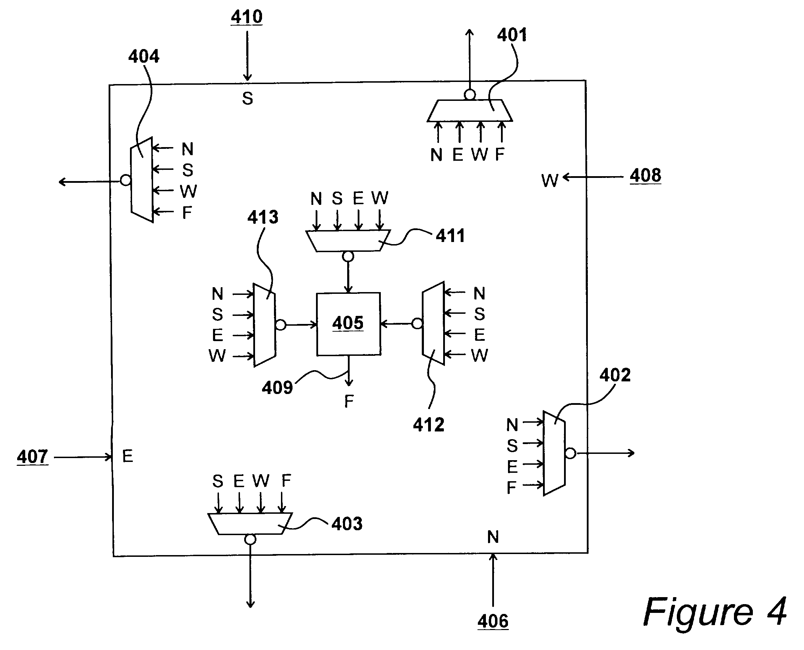

The circuit of an individual logic cell **301** is detailed in *Figure 4.* Outputs from the cell are provided by multiplexers **401**, **402**, **403** and **404**. Inputs and outputs are considered using a North, South, East and West (NSEW) terminology. Additionally, the function output of the cell's programmable logic circuit **405** is given the term F. Thus the north-facing multiplexer **401** may route any of the signals N **406**, E **407** or W **408** from neighbouring cells, or the function F **409** from its own internal logic unit **405**. A similar arrangement is made for each of the other output multiplexers **402**, **403** and **404**, which may additionally receive an input from S **410**. The programmable logic function **405** receives three inputs from multiplexers **411**, **412** and **413**. Each of these multiplexers **411**, **412** and **413** receives inputs from each of the four N, S, E and W input signals, and delivers a function F that may be routed to any of the four outputs via multiplexers **401**, **402**, **403** and **404**. The multiplexers and the logic function are all defined, collectively, by an array of eighteen bits stored in an adjacent set of static RAM registers, that are not shown for reasons of clarity. In addition, the hierarchical routing that is provided on the chip is not shown in *Figure 4.*

The cell shown in *Figure 4* may provide routing, or a cell function, or both. In the present embodiment, only a proportion of the resources of the sixty-four by sixty-four array are utilised. A twelve by twelve array of functional cells is preferred. However, in order to improve routability, alternate cells are used purely as a routing resource, giving a total array of twenty-five by twenty-five cells, in which a sparse twelve by twelve matrix of logically functional cells is considered as the main resource. Hereinafter, the array will be considered as a twelve by twelve array, and it will be understood that this includes the blank cells provided for additional routability.

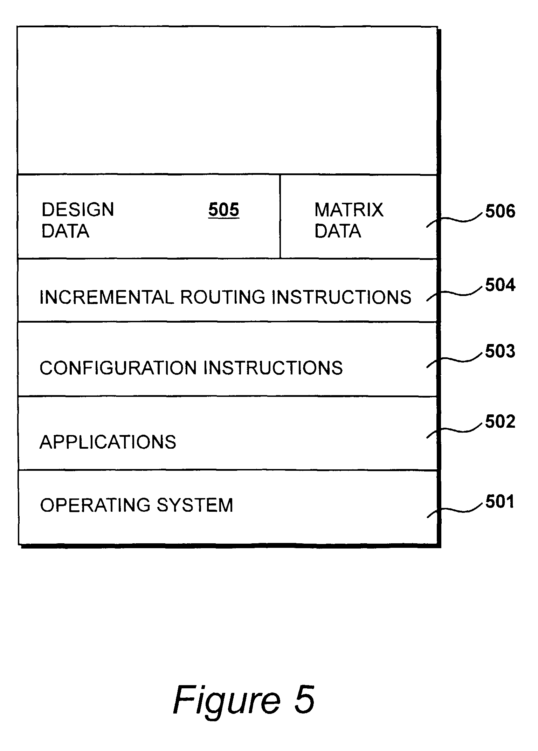

The contents of the computer memory **202**, shown in *Figure 2,* are detailed in *Figure 5.* A Windows '98 operating system **501** provides common application functionality for the computer circuit shown in *Figure 2.* Applications **502** include several utilities that are commonly provided when running the operating system **501**, along with additional instructions relating to the present invention. Configuration instructions **503** provide instructions for generating configuration data for the FPGA **209**. Incremental routing instructions provide instructions for routine designs generated by the configuration instructions **503**. Design data **505**, includes all the data that relates to designs that are to be tested on the FPGA, and matrix data includes read-only data for generating FPGA designs.

Field programmable gate arrays are intended to replace digital signal processors and custom processing circuits in a wide variety of applications. As cell capacities of FPGAs increase, and prices drop, the ability to update increasingly complex circuits, without having to modify or redesign existing hardware, has made these devices increasingly useful. In the invention, however, an FPGA is being used in an entirely different way.

The reconfigurability of an FPGA may be used to automatically evolve a circuit to achieve a desired function, without design. This approach is described in "Hardware Evolution - Automatic Design of Electronic Circuits in Reconfigurable Hardware by Artificial Evolution" by Adrian Thompson, ISBN 3-540-76253-1. A genetic algorithm is applied to generate multiple FPGA designs from an initial set of random configurations, and a fitness function is applied to test correlation with the desired function. The application of the genetic algorithm results in an evolution of circuits towards the desired functional goal. Although it is conceivable that purely digital circuits may be evolved in this way, the approach taken by Thompson, and by the present embodiment, is to use the cells as analogue components.

In synchronous digital circuits, outputs from logical components such as gates, adders and multipliers are synchronised using a register whose output is updated on the rising or falling edge of a clock signal. This ensures that partial results from a logical process do not result in instability when feedback is used. Registers are clocked at a rate slow enough to insure that logic circuits settle before their outputs are used in the next stage of processing. In an FPGA, cells may be configured so as to provide synchronous logical functionality in this way. However, if clocked registers are not used, feedback loops may be created that result in instability and highly complex behaviour. When used in this way, each cell may be considered as an extremely high gain analogue amplifier. In an evolved circuit, it is possible to take advantage of the complex behaviour that emerges from multiple feedback paths between amplifiers and their inputs. In "Hardware Evolution", Thompson describes how a ten by ten array of cells in an XC6216 FPGA was automatically configured to distinguish between signals of 1kHz and 10kHz, providing a 0V or +5V output on one of its pins. After three thousand iterations of the genetic algorithm, only thirty-seven cells were required to perform this function.

In hardware evolution, the design of the circuit is a function of the genetic algorithm and the fitness function. Provided that these are implemented effectively, and that the effect required is within the realms of physics, it is possible for any desired function to be implemented using a circuit of this type. On page 199 of "The Conscious Universe", an apparatus is described in which a matrix of random number generators is used to improve the detection of consciousness-related phenomena. However, no underlying theory behind consciousness effects has been established, and such designs rely on a particular conjecture about these mechanisms being correct. Thus, without a theory to underpin the observable influence of consciousness upon random events, it is impossible to design a device that will improve upon the existing methods of random event analysis. The invention avoids the design process by using hardware evolution. Furthermore, improvements over known methods of hardware evolution are provided, in order to facilitate a convergence towards the desired function.

In the preferred embodiment, each design is a configuration of a matrix of twelve by twelve functional cells. These are interleaved with passive rows and columns of cells that are provided to increase routability of designs. A genetic algorithm is implemented, using methods described in 'The Artificial Evolution of Adaptive Behaviour', by Inman Harvey, published at the University of Sussex, England, in 1993 and revised in 1995.

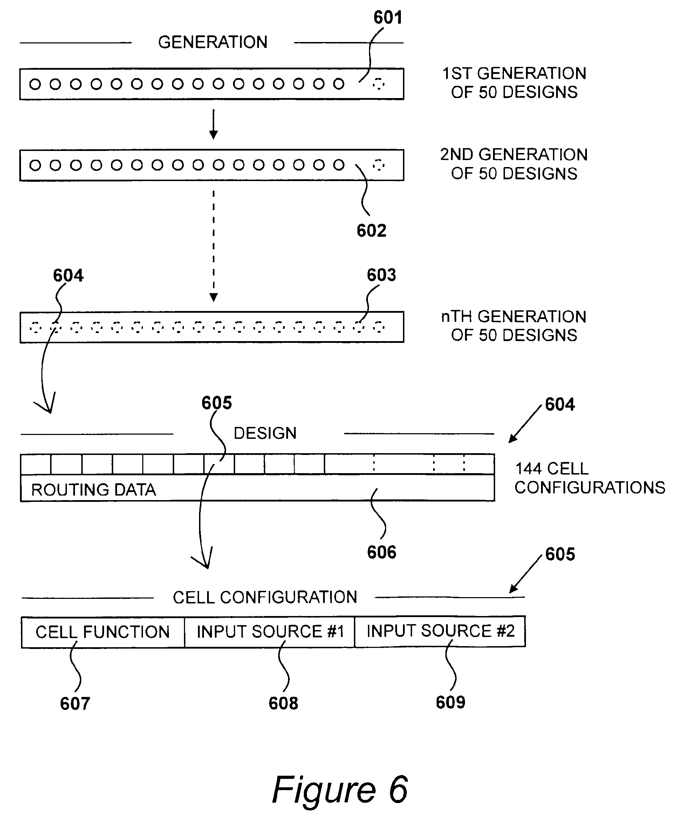

In the genetic algorithm, fifty designs for the FPGA are used for each generation. This is illustrated in Figure 6. A first generation 601 of fifty designs is generated substantially at random. Fitness tests are then performed on each of these fifty, and based on the results, a second generation is created, embodying the characteristics of the best first generation designs. A mutation rate is also defined, so that, as each generation is created, new characteristics are gradually introduced that may be of benefit. Preferred mutation rates and parent selection are used, as described by Inman Harvey in the aforementioned reference. This results in a method that can continue to produce new generations that converge on the preferred circuit characteristics, or function, and that generates improvements to the circuit design by the additional information input resulting from random mutation.

Each design **604** comprises one hundred and forty-four cell configurations **605**, along with routing data **606** from the parents from which it was created. Each cell configuration includes three data fields. The first of these is the cell function **607**. This may be any one of the following:
0 - BUFFER
1 - NOT
2 - AND
3 - OR
4 - XOR
5 - NAND
6 - NOR
7 - NOT-XOR

Although these are described as logical functions, in practice their function is analogue, and the different functions may be considered as providing a different signal polarity on the inputs of an extremely high gain amplifier.

The second and third field represent an address of the location of cells whose function F is to provide an input. In order to improve routability of designs, the permissible cells that may be used to provide an input are constrained to cells that are within a certain routing distance. Routing distance is expressed as being a number of steps. Thus, for a preferred maximum routing distance of six, the most distant source of input is a cell six cells away in the horizontal or vertical directions. Along a diagonal, this distance is reduced due to the non-diagonal stepped nature of routing paths.

In the aforementioned "Hardware Evolution", routing is provided on an ad-hoc basis, with the routing function of each cell being considered individually without regard to the ultimate source and destination of cell functions: Each cell routes signals through or across itself according to its routing configuration data, and this is considered in isolation from routing configurations of other cells. This has the advantage that a routing algorithm is not required. Routing takes each connected source and destination in a circuit design, and attempts to find a path across the available routing resources in order to fulfil this requirement. Routing is a highly complex art, and routing designs may take a very significant amount of time and processing power. Furthermore, routing is extremely unlikely to be possible for an unconstrained random FPGA circuit design. A further problem with routing, in the context of hardware evolution, is that circuit behaviour is extremely subtle, and critically dependent upon characteristics not usually considered important. These include parasitic electromagnetic and capacitance effects, so that a cell may be affected by a route that passes through or near it. The route variation that would result from applying a routing algorithm to each generation of circuit designs would destroy a major source of the rich characteristics which hardware evolution uses to achieve complex functional behaviour from minimal circuit resources.

However, routing is a primary determinant of the overall circuit function. In the invention, routing is defined at the circuit level. The invention provides a method for combining routings from different parents, as is required for the genetic algorithm. It does this by retaining most routing data from the parents of a design, so that the actual routes are mostly unchanged, and, furthermore, only newly evolved routes need to be routed by a routing algorithm.

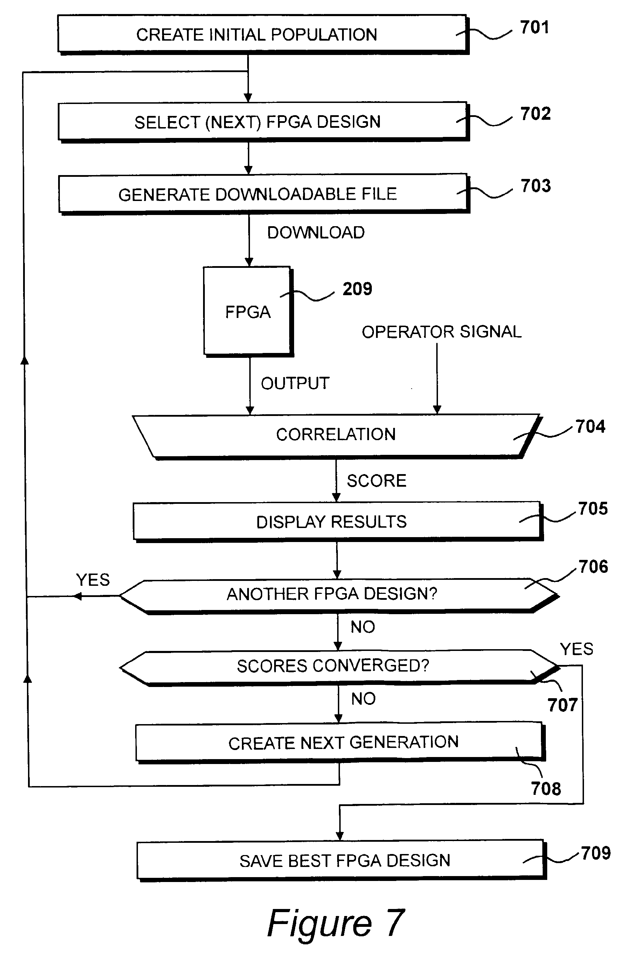

Steps performed by the environment shown in *Figure 1* are summarised in *Figure 7*. At step **701** an initial population of fifty designs is created. Each design comprises one hundred and forty-four cell configurations, upon a matrix of twelve by twelve functional cells, having interleaved cells used for routing only, resulting in an overall matrix of twenty-five by twenty-five cells.

At step **702** the first design of the present generation is selected. At step **703**, a downloadable file is generated, which comprises the bit patterns for serially configuring the FPGA **209**. On the first iteration, none of the designs **604** can inherit any routing data **606** from the previous generation. Therefore, at this stage, a routing algorithm performs a complete routing of the design. On subsequent iterations, only incremental routing is required.

At step **704** a fitness test is performed. A correlation is performed between the output **210** from the pin of the FPGA **209**, and an ideal signal. This correlation is performed in response to a signal indicating the occurrence of an operator intention. The result of the correlation process **704** is a score, which is displayed on the monitor **104**. The score represents the fitness of the design. At step **706** a question is asked as to whether another design is to be tested from within the present generation. If so, control is directed to step **702**. Alternatively, control is directed to step **707**, where a question is asked as to whether the scores have converged. At some point, after many generations, the improvement in the score will asymptotically converge, after which the improvements in circuit function are outweighed by the time and effort required for the correlation step.

If another generation is required, control is directed to step **708**, where the next generation of fifty designs is created. Thereafter, control is directed to step **702**, whereafter each of the next population of fifty designs is tested, as described above. Once the fitness score has converged, control is directed to step **709**, where the design with the best score is saved for later use. All designs in the final generation may be saved, so that further iterations may be performed at a later time. Alternatively all designs in several generations are saved, so that subsequent analysis can be performed to determine possible improvements to the correlation step.

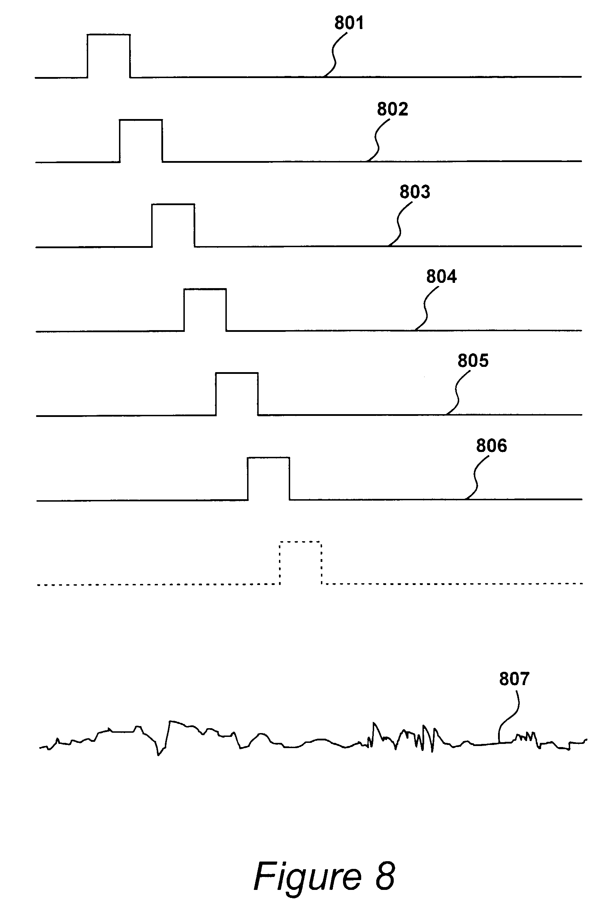

Ideal signals from the output of the FPGA are illustrated in *Figure 8.* Twenty ideal signals are provided, examples of which are shown at **801** to **806**. These are pulse waveforms of duration in the order of twenty milliseconds. The ideal signals comprise a pulse duration that varies incrementally through time, thus enabling capture of a response to an operator intention that may occur within a short but unpredictable time period. An example of an early evolved signal, as measured by the signal detector **212** from the FPGA **209**, is shown at **807**. A real signal such as signal **807**, consists of a stream of data samples. These are correlated with each of the ideal signals **801** to **806**. The best correlating ideal signal is identified, and the overall score for the correlation step is considered as the correlation between the identified ideal signal and the actual waveform received from the FPGA **209**.

The convergence of designs to a desired function is the purpose of hardware evolution. However, in the present invention, an operator is required to attune their intention to the FPGA in such a way that their intention will result in an electrical response being generated by the circuit. The attention, state of mind and attitude of the operator are therefore important factors in the generation of useful results. It may be assumed that the operator's effectiveness is variable, just as the function of the FPGA is for each design.

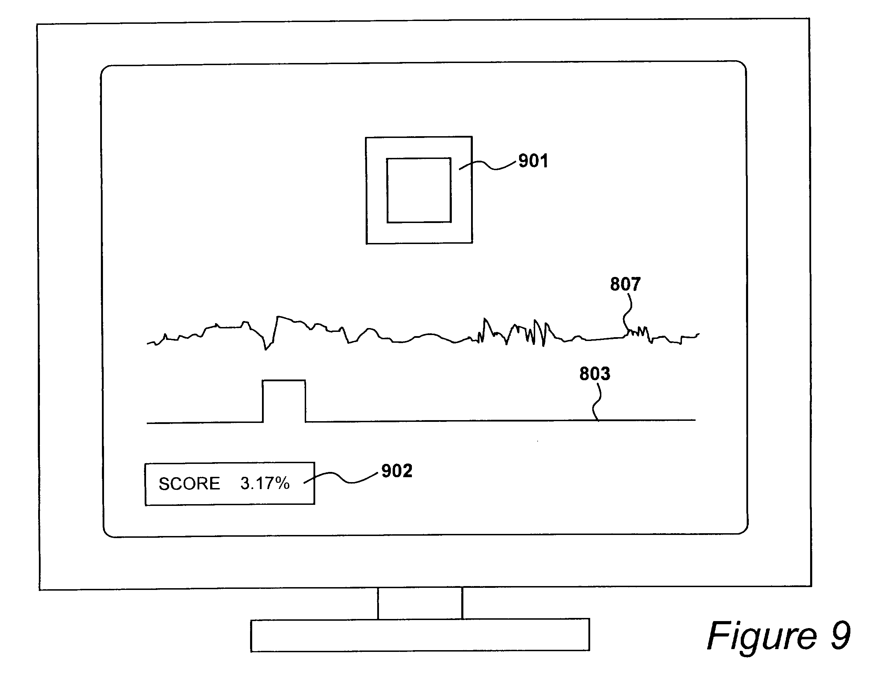

Feedback is provided to the operator in the form of a display on the monitor, as shown in *Figure 9.* The sequence of steps performed by the operator goes in the following way: The operator waits until ready, and presses a key on the keyboard **102**. The computer waits for a random period of time, and displays an image of the FPGA **901**. As described in "Consciousness and Anomalous Physical Phenomena", PEAR Technical Report 95004, Princeton Engineering Anomalies Research, the mental relationship between the operator and the device affects the degree to which correlation is obtained. The appearance of the FPGA **901** is intended to provide a visual identification with the actual device to which the operators intention should be applied. At the same time as the device is shown, a real signal **807** is recorded. Correlation is performed, and the best fitting ideal response **803** is identified. Both the real and closest fitting ideal response are displayed, and the correlation between them **902** is also displayed. This provides immediate feedback to the operator, so that it becomes possible to determine the most effective form of intention. Thus, while the results of the FPGA continue to improve, the operator can also improve performance. This dual convergence of the hardware and the operator speeds up the evolution process and directs it more precisely towards the required circuit function. The correlation sequence is performed several times for each circuit, so as to generate an overall fitness score.

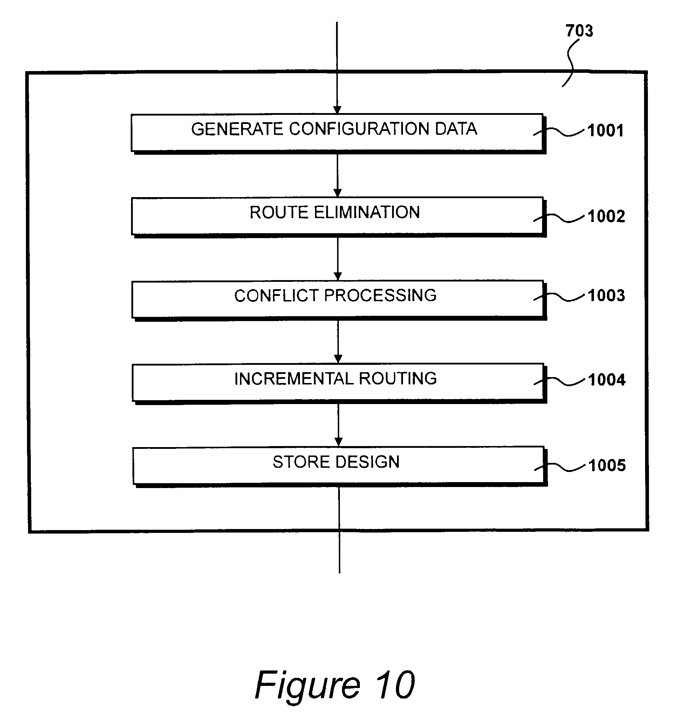

The step of generating a downloadable file **703**, shown in *Figure 7,* is detailed in *Figure 10.* At step **1001** configuration data is generated by considering each of the cell configurations **605** for the design **604.** At step **1002** route elimination is performed. This removes routing data **606**, saved from the parents, that is no longer applicable to the present design **604**. In routing terminology, cell outputs are considered as route sources and cell inputs are considered as route sinks. Routes are eliminated where a route starting at a source in the part of the design due to a first parent ends up at a sink in the part of the design due to the second parent, when both parents do not share the same sink. At step **1003**, conflict processing removes conflicting routing data. Combining the routing data from both parents remnants often results in some overlap of routing paths. These paths have to be deleted and re-routed. At step **1004** incremental routing is performed. New routes are required for a couple of conditions. Firstly, when a new route has been generated as a result of a mutation in an input source value **608** or **609** in a cell configuration, and secondly, when conflict processing **1003** has resulted in routing data for an input connection being deleted. When the first generation of fifty designs is processed at step **1003**, no routing data **606** exists, and so the routing is performed for all inputs on this initial iteration. At step **1005** the design data is stored, including routing data generated at step **1004**.

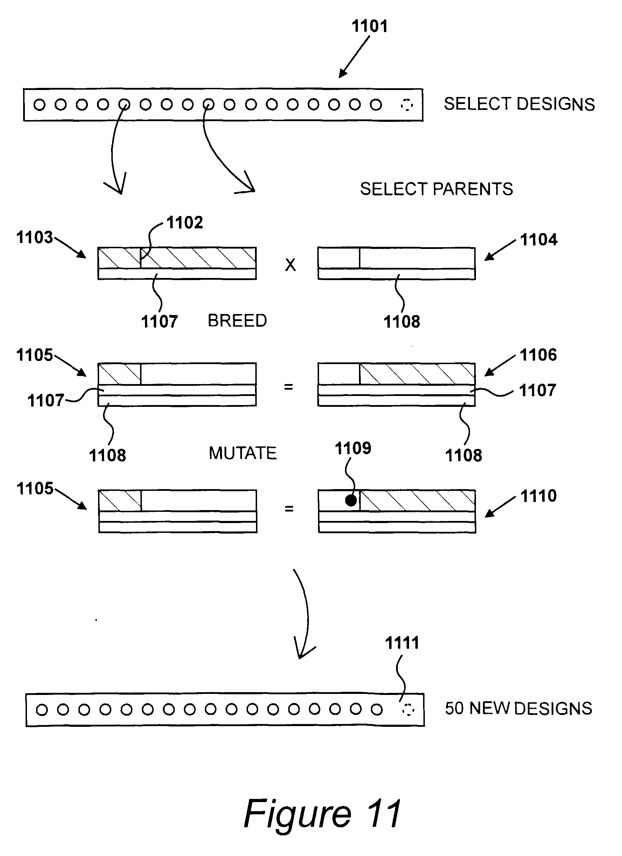

The step of creating the next generation **708**, shown in *Figure 7,* is performed in accordance with a known algorithm described by Inman Harvey in the aforementioned reference. This process is illustrated in *Figure 11.* A population of fifty designs **1101** has been scored. The algorithm includes selection of the single best design from the previous generation for inclusion, unaltered, in the next generation. Thirty percent of the previous generation are selected for sexual reproduction in which two designs are combined by splicing their design data at a cut-off point to generate a child design. Sixty-eight percent of the previous generation are selected for a mutation process only. Selection of circuits from a previous generation for sexual reproduction or mutation only is performed with respect to their scores, as described in the aforementioned reference by Inman Harvey.

Parents for reproduction are selected randomly, with a bias towards the higher-scoring designs. A random crossover point **1102** is selected between the first cell and the last cell. A mother and father **1103** and **1104** swap segments to create a pair of children **1105** and **1106**. The routing data **1107** and **1108** for each parent is associated, by way of pointers, with both children, so that this data may be used for valid routes in the newly created individuals.

When mutation is applied, this may result in a change to a bit of data **1109** in a design **1106**, resulting in a mutated design **1110**. If mutation affects an input field **608** or **609**, the old route will be deleted at step **1002**, and a new route is created at step **1004**. Fifty new designs **1111** are created in this way from the previous generation **1101**.

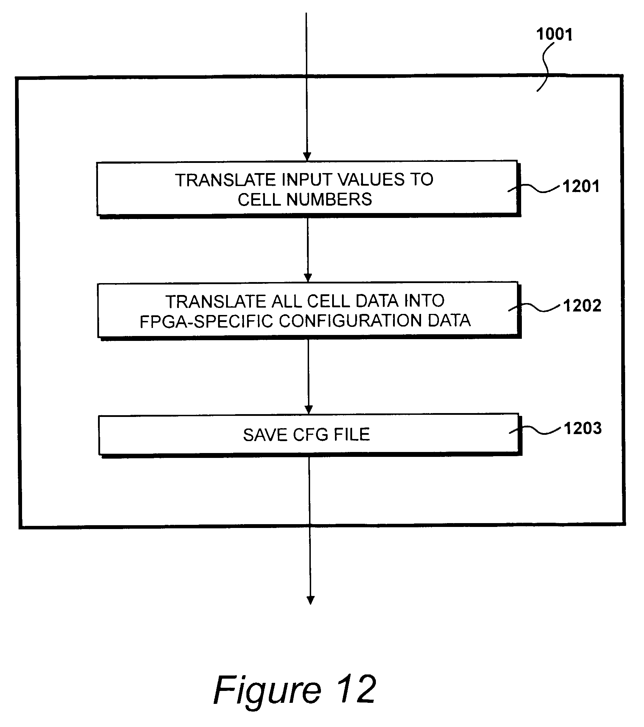

The step of generating configuration data **1001** shown in *Figure 10,* is detailed in *Figure 12.* At step **1201** any new input values **608** and **609** are translated into cell numbers. This translation need only be performed when a mutation has resulted in a change of either of the input values **608** and **609**. When translating, only cells within a certain distance may be connected, and so a constraining function is used. At step **1202** all cell data is translated into FPGA-specific data. For example, data for cells numbered from zero to one hundred and forty-four is translated into data for cells at the appropriate physical locations in the chip, within a fixed twenty-five by twenty-five grid of cells that are used. At step **1203** the FPGA-specific configuration data is saved as a CFG file for later processing.

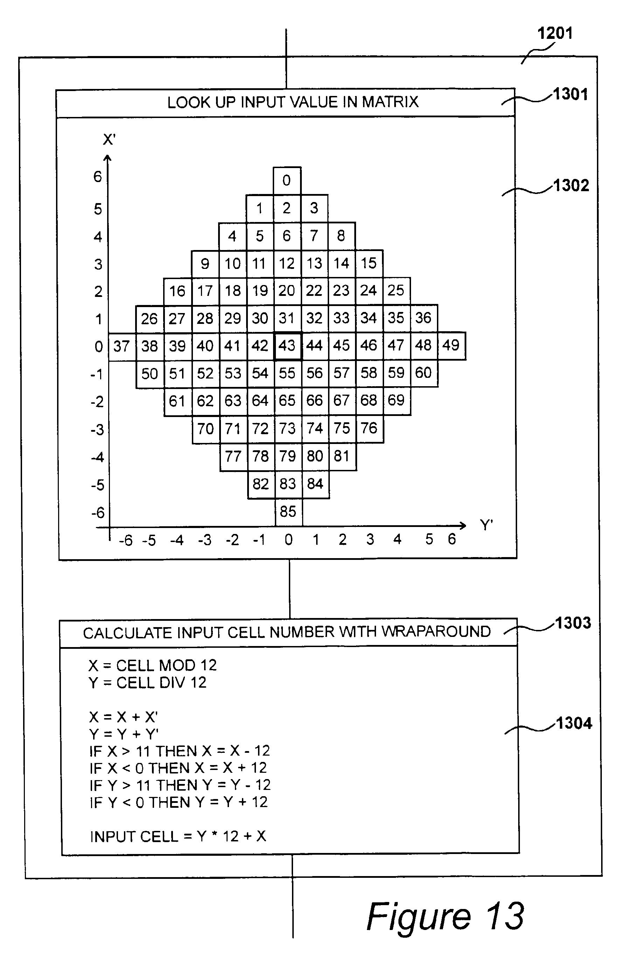

The step of translating input values to cell numbers, shown at step **1201** in *Figure 12*, is detailed in *Figure 13.* At step **1301** the input value of each input **608** and **609** is looked-up in a matrix. The matrix is illustrated at **1302**. The matrix takes a value from zero to eighty-five, and generates X' and Y' offset co-ordinates from the present cell. In the first generation, created at step **701**, these values are created entirely at random. Thereafter they are generated by the process illustrated in *Figure 11.* A value of forty-three results in the input to the present cell being defined as its own output. A corresponding X' and Y' value is given as zero. By mapping input values in this way, the inputs **608** and **609** may only be connected to the outputs of cells within a certain routing distance. In this case, the distance is six steps in any direction. By constraining the routing in this way, as opposed to allowing any cell from one to one hundred and forty-four to connect to any other, routing of designs becomes feasible. A pure random selection of routes will often result in designs that cannot be routed, simply due to the limitations of the routing resources provided by the XC6216 FPGA.

At step **1303** the matrix value is combined with the present cell number to give the cell number of the input source. This includes wraparound processing for when the matrix generates a value that would result in a cell being located off the edge of the twelve by twelve cell array that has been designated for use. The processing steps assume a present cell index of zero to one hundred and forty-three. This is translated into two dimensional co-ordinates X and Y, having each a range of zero to eleven. These are then combined with the X' and Y' values from the matrix, constrained to wraparound the twelve by twelve co-ordinate system, and then converted back into a cell number in the range zero to one hundred and forty-three. This process is performed for both input values **608** and **609** to generate two cell values defining the sources of the input of a cell.

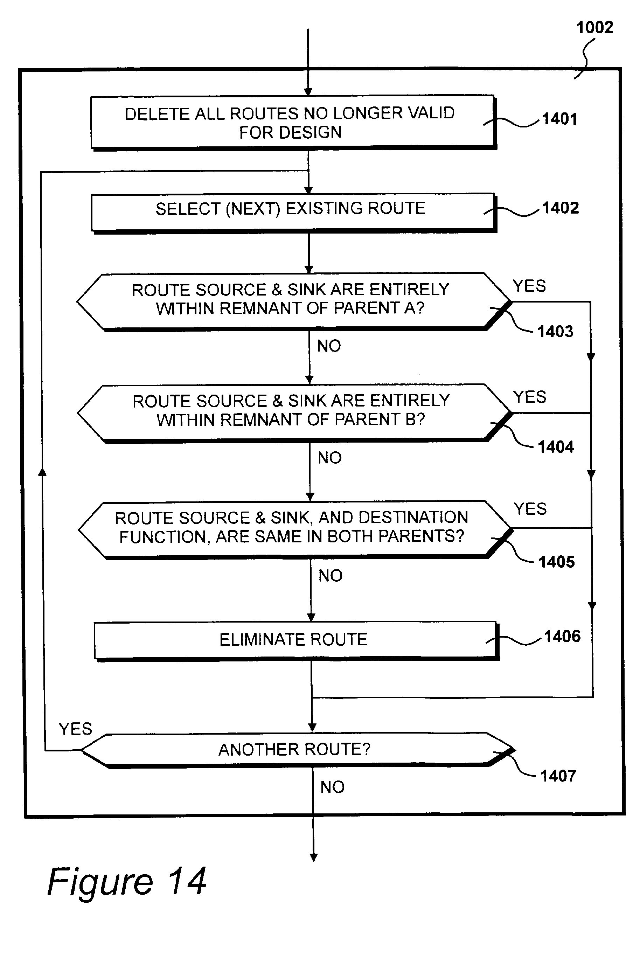

The process of route elimination **1002**, shown in *Figure 10,* is detailed in *Figure 14.* At step **1401** all routes no longer valid for the design are deleted from the routing data **606**. Each child **1105** inherits routing data from both mother **1103** and father **1104**. Only part of each parent's routing data is valid for the new design **1105**. It is the invalid data from the parents that is deleted at step **1401**.

At step **1402**, the first of the routes in the remaining routing data is identified. At step **1403** a question is asked as to whether the route source and sink are entirely within the remnant of parent A. If so, control is directed to step **1407**. Alternatively, control is directed to step **1404**, where a question is asked as to whether the route source and sink are entirely within the remnant of parent B. If so, control is directed to step **1407**. Alternatively, control is directed to step **1405**, where a question is asked as to whether the source and sink, and destination cell function are the same in both parents. If so, control is directed to step **1407**. Alternatively, control is directed to step **1406**, where the route is eliminated from the remaining routing data.

For example, if cell nine receives an input from cell three, then this route is retained because it does not cross the crossover point of cell number twenty, where the genetic splicing took place to breed the design. Alternatively, if an input for cell nine is from cell ninety, then this may not be valid in the design. The output from cell ninety is traced in the routing data **1108** of parent B to determine its destination. If one of the destinations is cell nine and the functions and inputs of cell nine are the same in parent and child, the routing is kept. As designs converge, this situation occurs with increasing frequency, and the valuable routing that evolves may cross the threshold of cell twenty without being lost in the breeding process.

At step **1407** a question is asked as to whether another route is to be considered. If so, control is directed to step **1402**. Alternatively, this marks the end of the route elimination process **1002**.

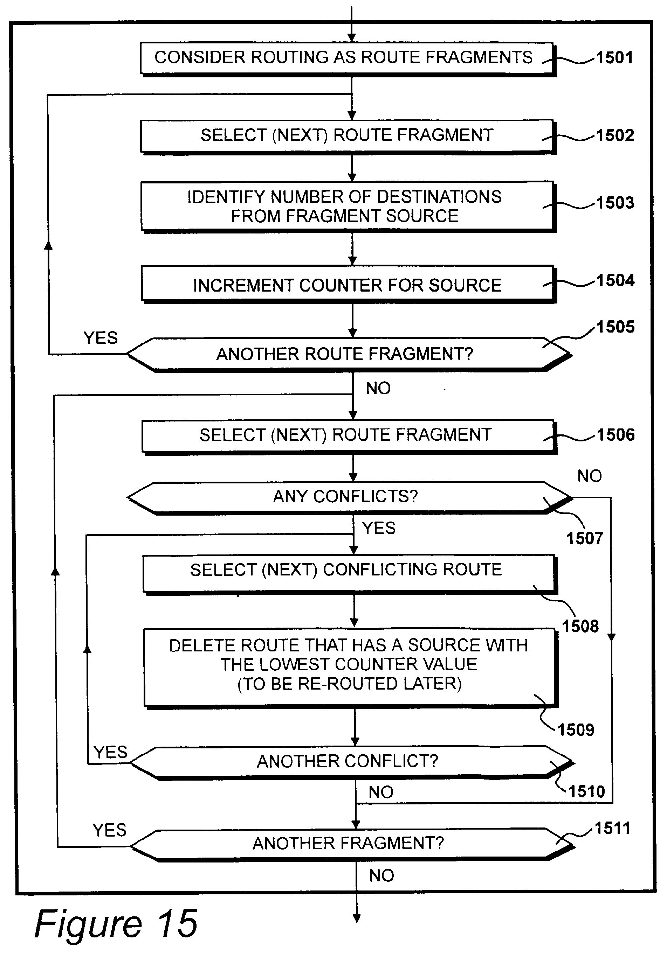

The step of conflict processing **1003** shown in *Figure 10* is detailed in *Figure 15.* At step **1501** routing data for the design is considered as a set of route fragments. Routing in the XC6216 is created from routing resources using multiplexers **401** to **404** shown in *Figure 4.* These routing resources provide each cell with the ability to route a signal from an external input **406**, **407**, **408** or **410** without a function being applied. In addition to cell level routing resources, the XC6216 provides hierarchical routing resources that carry connections between sub groups of four by four cells. The XC6216 also provides hierarchical routing at the sixteen by sixteen and sixty-four by sixty-four group level. To provide a route between a cell output and input requires that the routing algorithm **1004** uses these to build-up a route that includes multiple individual cross-cell routings, or alternatively or in addition to, cross-group routings. Each individual routing component resource, whether it be a route from a cell to a neighbouring cell, or a route between groups of cells, is considered as a route fragment. A single route from a cell output or source, to a cell input or sink, may consist of multiple fragments.

The overall routing of a design is considered as a collection of many route fragments at step **1501**. Each route fragment is provided with its own unique identification number. Steps **1502** to **1505** consider each route fragment in turn. At step **1503** the source of the selected fragment is examined to see how many destinations it is routed to. Account is then made of the total number of routing fragments that include the selected fragment and emanate from the same source. This test is made easier by the inclusion of routing analysis data within the design routing data **1107**. At step **1504**, the number determined at step **1503** is added to a counter associated with the fragment source. In this way, the amount of use of each routing fragment is measured, irrespective of the fragment's length. Important fragments within a design may be considered as those fragments that are shared by many long routings from a single source to many syncs. Steps **1501** to **1505** perform a measure of this importance with respect to each fragment that is used for routing in the design.

Steps **1506** to **1511** select each route fragment again, identify any conflicting routes and delete the route/routes connected to a source having the lowest fragment counter value and which share the conflicting fragment. If the counter values are equal, it does not matter which is chosen. The intention here is to eliminate those routings which will require the least amount of incremental routing to replace, thereby retaining as much as possible of the parental routing.

A route conflict occurs when the same cell routing resource has been used by both parents of a design, and this data has been carried through to the remaining routing data of the child. If all routing for the remnants of the father were confined to routing resources of cells one to twenty, and all routing for the remnants of the mother were confined to the routing resources of cells twenty-one to one hundred and forty-four, then route conflicts would not occur. However, routing algorithms meander in order to make possible complex interwiring patterns, and so cells particularly in the border region of the design around cell twenty, may be responsible for routes in either part of the new design. It is here that it is possible for route conflicts to occur, and so this is the purpose of the conflict processing shown in *Figure 15.*

Hardware evolution in the manner described above results in designs that take full advantage of many subtle aspects of the components on the FPGA. Translation to other FPGA devices, from the same manufacturing process, may not operate as well, or at all, due to the variations between manufactured circuits. It is known that when moving the cell matrix from the north-west of the FPGA gate array to the south-east, variations across the silicon are sufficient to disrupt the operations of a design that has evolved under very particular conditions. This sensitivity is partly what yields the rich behaviour that can be utilised to implement a highly functional device. However, it is possible to reduce critical dependence upon these parameters, and others such as temperature variations, by exposing the evolutionary process to such variations.

Selection of designs that are successful across such variables tends to favour an invariance to them. The evolutionary process takes longer when exposed to variations. Nevertheless, provided that a design is possible within the laws of physics, and a suitable fitness test can be devised, the design will converge to provide a circuit having the required function, while providing a useful level of invariance to environmental and manufacturing tolerances.

Once a design has been evolved using the configuration system shown in *Figure 1,* the design may be used in a circuit such as that shown in *Figure 16*. An FPGA **1601** contains the design that was saved at step **709**. A detector and driver circuit **1602** performs necessary signal detection and conditioning to supply a control voltage to a triac **1603**. The triac conducts when a suitable control voltage is applied, and this results in the conduction of AC current through an electrical device such as a light bulb **1604**, connected to an AC mains supply **1605**. To facilitate manufacture, a final generation of fifty designs developed for operation generally on all FPGAs may be used as a starting point for optimisation for specific FPGAs having minor manufacturing variations.

Considerable time and effort are required to generate the converged design initially. However, for each FPGA upon which the design is to operate, only a minor training sequence is required, after which it may be inserted into the required circuit, such as the one shown in *Figure 16.* The detector **1602** may respond to a pattern of triggers, so as to provide a unique means of identification of an operator, and the electrical device **1604** may be a lock, or some other electrically operated security apparatus.

## Claims

1. A method of configuring a circuit (**209**) to be responsive to an operator intention, wherein a configurable circuit has a plurality of function means and re-configurable routing means for said function means, characterised by the steps of:
generating (**701**) designs for configurations of said circuit; followed by repeated steps of:
(a) testing said circuit designs by measuring (**704**) an indication of responsiveness to an operator intention;
(b) selecting preferred designs; and
(c) generating (**708**) next designs from said preferred designs.

2. A method of evolving a circuit configuration so that said circuit becomes responsive to an operator intention, wherein a processing means is configured to generate and test circuit configurations, wherein said configurations are defined by a design, characterised by the steps of:
creating (**701**) an initial population of circuit designs, and for each of said designs; performing the steps of:
(a) configuring (**703**) said circuit in response to a selected one of said circuit designs;
(b) receiving an indication of an operator intention;
(c) correlating (**704**) an output from said configured circuit with said operator intention; and
(d) selecting (**709**) a preferred design in response to said correlation.

3. A method of training a configurable circuit to generate an electrical signal coincident with an operator intention, wherein a processing means is instructed to generate and test circuits for a configurable circuit, characterised by an initial step of:
creating (**701**) an initial set of circuit configuration designs; and, followed by the repeated steps of:
(a) configuring (**703**) said circuit (**209**) in response to selected ones of said designs;
(b) receiving an operator signal indicating an operator intention;
(c) correlating (**704**) an output from said configured circuit with said operator signal;
(d) selecting (**708**) a preferred design in response to said correlation; and
(e) generating subsequent preferred designs by combining characteristics from selected preferred designs.

4. A method according to claim **3** wherein said step of generating subsequent preferred designs by combining characteristics from selected preferred designs includes combining routing characteristics.

5. A method according to claim **4**, wherein routing characteristics are generated by
(a) generating configuration data,
(b) eliminating routes,
(c) processing to identify conflicts, and by
(d) incremental routing.

6. A method according to claim **5**, wherein said step of generating configuration data includes restricting cell input sources by constraining a cell input connection in response to a routing cost.

7. A method according to claim **6**, wherein said routing cost is characterised by a number of routing steps.

8. A method according to claim **6**, wherein said cell inputs are constrained using a look-up table.

9. A method according to claim **3**, wherein a visual display apparatus provides a visual indication to said operator of a result of an operation of said configurable circuit.

10. A method according to claim **3**, wherein a visual display apparatus provides a visual association with the device that is being configured.

11. A method of generating an electrical signal in response to an operator intention, by analysing an output from a circuit configured in accordance with the method of claim **1**.

12. A method of configuring a circuit to perform a required function, wherein a configurable circuit has a plurality of function means and reconfigurable connection means for said function means, characterised by the steps of:
(a) generating designs for configurations of said circuit; followed by repeated steps of:
(b) generating routing data for said designs;
(c) testing said circuit designs by measuring an indication of said required function;
(d) selecting preferred designs; and
(e) generating next designs from said preferred designs.

13. A method according to claim **12**, wherein said designs are generated by constraining the routing distance between said function means.

14. A method according to claim **12**, wherein said designs are generated for a matrix of said function means interleaved with non-active function means configurable mainly as routing means.

15. A method according to claim **12**, wherein said step of generating routing data includes a step of incrementally routing a design using data from a previously routed design.

16. A method according to claim **12**, wherein said step of generating routing data includes the steps of:
(a) generating configuration data;
(b) eliminating routes;
(c) processing for conflicts; and
(d) performing incremental routing.

17. A method according to claim **16**, wherein said step of generating configuration data includes constraining cell inputs in response to a routing cost.

18. A method according to claim **16**, wherein said step of route elimination removes routes that are no longer valid in a design in a generation created by artificial evolution.

19. A method according to claim **16**, wherein said step of conflict processing includes steps of:
identifying conflicting routes; and
eliminating non-preferred conflicting routes.

20. A method according to claim **19**, wherein said step of identifying conflicting routes is preceded by a step of:
counting a value associated with a routing source, and said step of eliminating non-preferred conflicting routes is preceded by a step of:
identifying non-preferred conflicting routes by comparing the number of routing steps that store the routing resource connected to a route source.

21. Apparatus for training a configurable circuit to generate an electrical signal coincident with an operator intention, wherein a processing means is instructed to generate and test circuits for a configurable circuit, characterised by
creating means for creating an initial set of circuit configuration designs;
configuring means for configuring said circuit in response to selected ones of said design;
receiving means for receiving an operator signal indicating an operator intention;
correlating means for correlating an output from said configured circuit with said operator signal;
selecting means for selecting a preferred design in response to said correlation; and
generating means for generating subsequent preferred designs by combining characteristics of selected preferred designs.

22. Apparatus according to claim **21**, wherein said generating means includes means for combining routing characteristics.

23. Apparatus according to claim **22**, including means for generating said routine characteristics by generating configuration data, eliminating routes, processing to identify conflicts and by incremental routing.

24. Apparatus according to claim **23**, including means for generating said configuration data configured to restrict cell input sources by constraining a cell input connection in response to a routing cost.

25. Apparatus according to claim **24**, wherein said routing cost is characterised by a number of routing steps.

26. Apparatus according to claim **24**, including means for constraining said cell inputs using a look-up table.

27. Apparatus according to claim **21**, including a visual display apparatus to provide a visual indication to a said operator of a result of an operation of a said configurable circuit.

28. Apparatus according to claim **21**, wherein a visual display apparatus provides a visual association with the device that is being configured.

29. A computer-readable medium (**106**) having computer-readable instructions executable by a computer such that, when executing said instructions, a computer will perform the steps of:
training a configurable circuit to generate an electrical signal coincident with an operator intention, wherein a processing means is instructed to generate and test circuits for a configurable circuit, characterised by an initial step of:
creating (**701**) an initial set of circuit configuration designs; and, followed by the repeated steps of:
(a) configuring (**703**) said circuit (**209**) in response to selected ones of said designs;
(b) receiving an operator signal indicating an operator instruction;
(c) correlating (**704**) an output from said configured circuit with said operator signal;
(d) selecting (**709**) a preferred design in response to said correlation; and
(e) generating subsequent preferred designs by combining and mutating characteristics from selected preferred designs.

30. A computer-readable medium having computer-readable instructions according to claim **29**, wherein said step of generating subsequent preferred designs by combining characteristics from selected preferred designs includes combining routing characteristics.

31. A computer-readable medium having computer-readable instruction according to claim **30**, wherein routing characteristics are generated by generating configuration data, eliminating routes, processing to identify conflicts and by incremental routing.

32. A computer-readable medium having computer-readable instructions according to claim **31**, such that when a computer executes said instructions, said step of generating configuration data includes restricting cell input sources by constraining a cell input connection in response to a routing cost.

33. A computer-readable medium having computer-readable instructions according to claim **32**, such that when a computer executes said instructions, said routing cost is characterised by a number of routing steps.

34. A computer-readable medium having computer-readable instructions executable by a computer such that when a computer executes said instructions said cell inputs are constrained using a look-up table.

35. A computer-readable medium having computer-readable instructions executable by a computer such that when a computer executes said instructions the visual display apparatus provides a visual indication to said operator of a result of an operation of said configurable circuit.

36. A computer-readable medium having computer-readable instructions according to claim **29**, such that when a computer executes said instructions, a visual display apparatus provides a visual association with the device that is being configured.
